# EUROPÄISCHE PATENTSCHRIFT

(11) **EP 3 273 473 B1**
(45) Veröffentlichungstag und Bekanntmachung des Hinweises auf die Patenterteilung: **09.09.2020**
(21) Anmeldenummer: 17179924.0
(22) Anmeldetag: 06.07.2017
(51) Int. Cl.: H01L 23/433, H01L 23/00, H01L 25/07

(54) **LEISTUNGSELEKTRONISCHE SCHALTEINRICHTUNG, ANORDNUNG HIERMIT UND VERFAHREN ZUR HERSTELLUNG DER SCHALTEINRICHTUNG**
POWER ELECTRONICS SWITCHING DEVICE, ARRANGEMENT USING THE SAME, AND METHOD FOR PRODUCING THE SWITCH DEVICE
DISPOSITIF DE COMMUTATION ÉLECTRONIQUE DE PUISSANCE, SYSTÈME LE COMPRENANT ET PROCÉDÉ DE FABRICATION DU DISPOSITIF DE COMMUTATION

(30) Priorität: 22.07.2016 DE 102016113538
(43) Veröffentlichungstag der Anmeldung: 24.01.2018
(73) Patentinhaber: SEMIKRON Elektronik GmbH & Co. KG, 90431 Nürnberg (DE)
(72) Erfinder: Ammon, Jörg, 91052 Erlangen (DE); Kobolla, Harald, 90556 Seukendorf (DE)

(56) Entgegenhaltungen:
- DE-A1- 4 132 947
- DE-A1- 10 121 970
- DE-A1-102013 108 185
- DE-A1-102014 106 570

## Beschreibung

Die Erfindung beschreibt eine leistungselektronische Schalteinrichtung, die eine Basiszelle eines Leistungshalbleitermoduls oder eines leistungselektronischen Systems ausbilden kann, indem sie alleine oder in Kombination mit weiteren, vorzugsweise identischen, Basiszellen den leistungselektronischen Grundbaustein des Leistungshalbleitermoduls oder des leistungselektronischen Systems bildet. Weiterhin beschreibt die Erfindung eine Anordnung mit einer derartigen leistungselektronischen Schalteinrichtung, sowie ein Herstellungsverfahren einer besonders bevorzugter Ausführungsformen einer derartigen leistungselektronischen Schalteinrichtung.

Aus dem Stand der Technik, beispielhaft offenbart in der DE 10 2013 104 949 B3, ist eine Schalteinrichtung mit einem Substrat, einem Leistungshalbleiterbauelement, einer Verbindungseinrichtung, Lastanschlusseinrichtungen und einer Druckeinrichtung bekannt. Hierbei weist das Substrat elektrisch isolierte Leiterbahnen auf, wobei auf einer Leiterbahn ein Leistungshalbleiterbauelement angeordnet ist. Die Verbindungseinrichtung ist als Folienverbund mit einer elektrisch leitenden und einer elektrisch isolierenden Folie ausgebildet und weist eine erste und eine zweite Hauptfläche auf. Hiermit wird die Schalteinrichtung intern schaltungsgerecht verbunden. Die Druckeinrichtung weist einen Druckkörper mit einer ersten Ausnehmung auf, aus der ein Druckelement hervorstehend angeordnet ist, wobei das Druckelement auf einen Abschnitt der zweiten Hauptfläche des Folienverbunds drückt und hierbei dieser Abschnitt in Projektion entlang der Normalenrichtung des

Leistungshalbleiterbauelements innerhalb der Fläche des

Leistungshalbleiterbauelements angeordnet ist.

Aus der DE 10 2014 106 570 A1 ist ein Leistungshalbleitermodul und eine Anordnung bekannt. Das Leistungshalbleitermodul ist ausgebildet mit einem Gehäuse, einer Schalteinrichtung mit einem dem Gehäuse verbundenen Substrat, einem hierauf angeordneten Leistungshalbleiterbauelement, einer Verbindungseinrichtung, Lastanschlusseinrichtungen und einer gegen das Gehäuse beweglich ausgebildeten Druckeinrichtung. Hierbei weist das Substrat eine erste mittige Durchgangsöffnung sowie gegeneinander elektrisch isolierte Leiterbahnen auf, wobei auf einer Leiterbahn ein Leistungshalbleiterbauelement angeordnet ist. Hierbei weist die Verbindungseinrichtung eine erste und eine zweite Hauptfläche auf und ist mit einer elektrisch leitenden Folie ausgebildet. Weiterhin weist die Druckeinrichtung einen Druckkörper mit einer zweiten zur ersten fluchtenden Durchgangsöffnung und mit einer ersten Ausnehmung auf aus der ein Druckelement hervorstehend angeordnet ist, wobei das Druckelement auf einen Abschnitt der zweiten Hauptfläche der Verbindungseinrichtung drückt und hierbei dieser Abschnitt in Projektion entlang der Normalenrichtung des Substrats innerhalb der Fläche des Leistungshalbleiterbauelements angeordnet ist. Hierbei sind die erste und zweite Durchgangsöffnung dazu ausgebildet ein Befestigungsmittel aufzunehmen, das das Leistungshalbleitermodul in der Anordnung auf einer Kühleinrichtung kraftschlüssig befestigt.

In der DE 101 21 970 A1 ist ein Leistungshalbleitermodul offenbart, bestehend aus einem Gehäuse, einem keramischen Substrat, schaltungsgerecht darauf angeordneten strukturierten und elektrisch leitenden Kontaktflächen, darauf angeordneten Bauelementen, einer Druckkontaktierung bestehend aus einem flexiblen Druckspeicher sowie einer den Druck erzeugenden Druckplatte sowie Leistungs- und Steueranschlüssen vorgestellt. Bei der Erhöhung der Leistungsfähigkeit, der Zuverlässigkeit sowie der Lebensdauer bei gleichzeitig verringerten Herstellungskosten sind veränderte Methoden der Aufbautechnologien für die einzelnen Bestandteile eine zwingende Voraussetzung. Dies wird erreicht durch eine flexible Leiterplatte die die Bauelement schaltungsgerecht miteinander und / oder mit den Kontaktflächen des Substrates verbindet wobei zur Isolation der Bauelemente gegeneinander ein flexibler Isolationsstoff eingebracht ist.

In der DE 10 2013 108 185 A1 wird ein Verfahren zur Herstellung einer leistungselektronische Schalteinrichtung offenbart. Hierbei wird ein Leistungshalbleiterbauelement auf einem ersten Bereich einer Leiterbahn eines Substrats oder auf einem ersten Abschnitt einer Verbindungseinrichtung angeordnet. Anschließend wird ein Isolierstoff, der dazu eingerichtet ist im Rahmen eines Umformungsprozesses eine adhäsive Kontaktfläche auszubilden, auf einem zweiten Bereich des Substrats, der dafür vorgesehen ist unmittelbar an einer Seitenfläche eines zugeordneten Leistungshalbleiterbauelements anzuschließen oder auf einem zweiten Abschnitt der Verbindungseinrichtung, der dafür vorgesehen ist an der Seitenfläche eines zugeordneten Leistungshalbleiterbauelements zu liegen zu kommen, angeordnet. Danach wird die Verbindungseinrichtung bündig zum Substrat angeordnet; danach wird die leistungselektronischen Schalteinrichtung mit einer Temperatur von 110°C bis 400°C und einem Druck von 5 MPa bis 50 MPa beaufschlagt, wobei gleichzeitig mindestens zwei Verbindungspartner miteinander stoffschlüssig verbunden werden und ein Umformprozess stattfindet, wodurch der Isolierstoff adhäsiv, stoffschlüssig, mit einem dritten Abschnitt der Verbindungseinrichtung und einem dritten Bereich des Substrats verbunden wird.

In der DE 41 32 947 A1 ist eine elektronische Schaltungsanordnung offenbart, mit einem Kühlbauteil, auf dem thermisch leitend und elektrisch isolierend ein Substratträger aufgebracht ist, auf dem mindestens ein zu kühlendes Leistungs-HalbleiterBauelement befestigt ist, das über Anschlußflächen zur elektrischen Verbindung mit den äußeren und schaltungsgerechten notwendigen internen Verbindungselementen kontaktiert ist, wobei wärmeleitende Pasten in definierter Dicke und Geometrie in dem Schichtaufbau vorgesehen sind und formstabile und wärmebeständige flexible Folien, die aus organischen Polymeren hergestellt und auch mit strukturierten Metallkaschierungen versehen sind, sog. flexible Leiterplatten mit ein oder mehrschichtiger Folge, abwechselnd Folie und Metall, auch mit metallischen Verbindungen zwischen zwei oder mehreren Schichten über metallisierte Durchbrüche, als Substratträger und/oder Verbindungselemente eingebaut sind.

In Kenntnis der genannten Gegebenheiten liegt der Erfindung die Aufgabe zugrunde, eine leistungselektronische Schalteinrichtung und eine Anordnung hiermit, sowie ein Verfahren zur Herstellung der Schalteinrichtung vorzustellen, wobei die Schalteinrichtung bezüglich ihrer Komplexität und ihres Herstellungsaufwands optimiert ist.

Diese Aufgabe wird erfindungsgemäß gelöst durch eine leistungselektronische Schalteinrichtung mit den Merkmalen des Anspruchs 1, durch eine Anordnung mit einer leistungselektronischen Schalteinrichtung mit den Merkmalen des Anspruchs 8 sowie durch ein spezielles Herstellungsverfahren mit den Merkmalen des Ansprchs 11. Bevorzugte Ausführungsformen sind in abhängigen Ansprüchen beschrieben. Die erfindungsgemäße Schalteinrichtung ist ausgebildet mit einem Substrat, einem hierauf angeordneten Leistungshalbleiterbauelement, mit einer Verbindungseinrichtung und mit einer Druckeinrichtung, wobei das Substrat gegeneinander elektrisch isolierte Leiterbahnen aufweist und auf einer der Leiterbahnen ein Leistungshalbleiterbauelement angeordnet ist, wobei ein adhäsiver Stoff zu dem Leistungshalbleiterbauelement und zu einer zugeordneten Leiterbahn zur haftenden Fixierung des Leistungshalbleiterbauelements auf dieser Leiterbahn angeordnet ist, wobei die Verbindungseinrichtung als Folienverbund mit einer elektrisch leitenden und einer elektrisch isolierenden Folie ausgebildet ist und somit eine erste und eine zweite Hauptfläche ausbildet, wobei die Schalteinrichtung mittels der Verbindungseinrichtung intern schaltungsgerecht verbunden ist und wobei eine Kontaktfläche der ersten Hauptfläche des Leistungshalbleiterbauelements mit einer ersten Kontaktfläche einer zugeordneten Leiterbahn des Substrats kraftschlüssig und elektrisch leitend verbunden ist, wobei das Leistungshalbleiterbauelement mit seiner zweiten Hauptfläche mit einer zugeordneten Kontaktfläche der ersten Hauptfläche der Verbindungseinrichtung kraftschlüssig und elektrisch leitend verbunden ist, hierzu die Druckeinrichtung einen Druckkörper und ein hiervon in Richtung des Leistungshalbleiterbauelements hervorstehendes Druckelement aufweist, wobei das Druckelement auf einen ersten Abschnitt der zweiten Hauptfläche des Folienverbunds drückt und hierbei dieser erste Abschnitt in Projektion entlang der Normalenrichtung des Leistungshalbleiterbauelements innerhalb der Fläche des Leistungshalbleiterbauelements angeordnet ist.

Es wird bei dieser Schalteinrichtung also explizit auf eine stoffschlüssige Verbindung der Kontaktfläche der ersten Hauptfläche des Leistungshalbleiterbauelements mit der zugeordneten Kontaktfläche des Substrats verzichtet. Hierdurch wird gegenüber dem Stand der Technik eine, bevorzugt als Drucksinterverbindung ausgebildete, stoffschlüssige Verbindung durch eine kraftschlüssige ersetzt.

Besonders bevorzugt ist es, wenn der Druckkörper eine erste Ausnehmung aufweist, aus der das Druckelement hervorsteht. Hierbei ist es weiterhin vorteilhaft, wenn diese erste Ausnehmung des Druckkörpers als Vertiefung ausgehend von einer ersten Hauptfläche ausgebildet ist, das Druckelement hierbei diese Ausnehmung des Druckkörpers vollständig oder annähernd vollständig ausfüllt und das Druckelement aus der Ausnehmung des Druckkörpers an dessen erster Hauptfläche in Richtung auf die Verbindungseinrichtung, genauer deren zweite Hauptfläche, hervorsteht. Hierbei sollte das Verhältnis aus lateraler Ausdehnung zu vertikaler Ausdehnung des Druckkörpers ein Verhältnis von mehr als 2 zu 1, insbesondere von mehr 4 zu 1, aufweisen.

Vorzugsweise weist der Flächeninhalt des ersten Abschnitts der zweiten Hauptfläche des Folienverbunds mindestens 20%, insbesondere mindestens 50% der Fläche des zugeordneten Leistungshalbleiterbauelements auf. Hierbei wird unter Fläche des Leistungshalbleiterbauelements dessen gesamte flächige Ausdehnung, also nicht nur diejenige der Anschluss- bzw. Kontaktflächen, verstanden.

Erfindungsgemäß ausgebildet ist die Anordnung mit einer vorbeschriebenen elektronischen Schalteinrichtung, mit einer Kühleinrichtung und mit einer Druckeinleiteinrichtung, wobei diese Druckeinleiteinrichtung sich mittelbar oder unmittelbar gegen die Kühleinrichtung abstützt, vorzugsweise mittig auf die Druckeinrichtung Druck einleitet und hierdurch die Schalteinrichtung kraftschlüssig mit der Kühleinrichtung verbunden ist.

Ebenso ist es auf Grund der besonders wirksamen Druckeinleitung möglich, dass zwischen Substrat, insbesondere demjenigen Teil des Substrats, auf dem die Leistungshalbleiterbauelemente angeordnet sind, und der Kühleinrichtung eine wärmeleitende Schicht, insbesondere eine Wärmeleitpaste, mit einer Dicke von weniger als 20µm, insbesondere von weniger als 10µm, insbesondere von weniger als 5µm angeordnet werden kann.

Ebenso kann es bevorzugt sein, wenn die Kühleinrichtung eine vorzugsweise metallische Grundplatte eines Leistungshalbleitermoduls oder ein Kühlkörper ist. Das erfindungsgemäße Verfahren zur Herstellung einer o.g. leistungselektronischen Schalteinrichtung weist die folgenden, vorzugsweise in dieser Reihenfolge anzuwendenden, Schritte auf:
a. Bereitstellen des Substrats mit einer Isolationslage und mit gegeneinander elektrisch isolierten Leiterbahnen;
b. Bereitstellen der Verbindungseinrichtung ausgebildet als Folienstapel alternierend ausgebildet mit zwei elektrisch leitenden, in sich strukturierten Folien und einer elektrisch isolierenden Folie zwischen den beiden leitenden Folien;
c. Anordnen des Leistungshalbleiterbauelements auf einer zugeordneten Leiterbahn;
d. Anordnen eines adhäsiven Stoffs zu dem Leistungshalbleiterbauelement und zu einer zugeordneten Leiterbahn zur haftenden Fixierung des Leistungshalbleiterbauelements auf dieser Leiterbahn;
e. Anordnen und haftendes Verbinden der Verbindungseinrichtung mit dem Substrat mittels des adhäsiven Stoffs;
f. Druckeinleitung mittels einer Druckeinrichtung und einer Druckeinleiteinrichtung auf die Verbindungseinrichtung derart, dass zwischen dem Leistungshalbleiterbauelement und der zugeordneten Leiterbahn des Substrats eine kraftschlüssige elektrisch leitende Verbindung ausgebildet wird, wobei sowohl zwischen der Verbindungseinrichtung und dem Leistungshalbleiterbauelement, wie auch zwischen der Verbindungseinrichtung und einer zugeordneten Leiterbahn eine kraftschlüssige elektrisch leitende Verbindung ausgebildet wird.

Selbstverständlich können, sofern dies nicht per se ausgeschlossen ist, die im Singular genannten Merkmale, insbesondere das Leistungshalbleiterbauelement, mehrfach in der jeweiligen leistungselektronischen Schalteinrichtung oder der Anordnung hiermit vorhanden sein.

Es versteht sich, dass die verschiedenen Ausgestaltungen der Erfindung einzeln oder in beliebigen Kombinationen realisiert sein können, um Verbesserungen zu erreichen. Insbesondere sind die vorstehend und im Folgenden genannten und erläuterten Merkmale, unabhängig ob sie im Rahmen der leistungselektronischen Schalteinrichtung, der Anordnung oder einem der Verfahren genannt sind, nicht nur in den angegebenen Kombinationen, sondern auch in anderen Kombinationen oder in Alleinstellung einsetzbar, solange der in den unabhängigen Ansprüchen definierte Rahmen der vorliegenden Erfindung nicht verlassen wird.

Weitere Erläuterung der Erfindung, vorteilhafte Einzelheiten und Merkmale, ergeben sich aus der nachfolgenden Beschreibung der in den Fig. 1 bis 5 dargestellten leistungselektronischen Schalteinrichtungen.
Figur 1 zeigt in Explosionsdarstellung eine Anordnung mit einer leistungselektronischen Schalteinrichtung.
Figur 2 bis 4 zeigen verschiedene Ausgestaltungen leistungselektronischer Schalteinrichtungen.
Figur 5 zeigt eine Draufsicht auf eine leistungselektronische Schalteinrichtung in verschiedenen Schnittebenen.

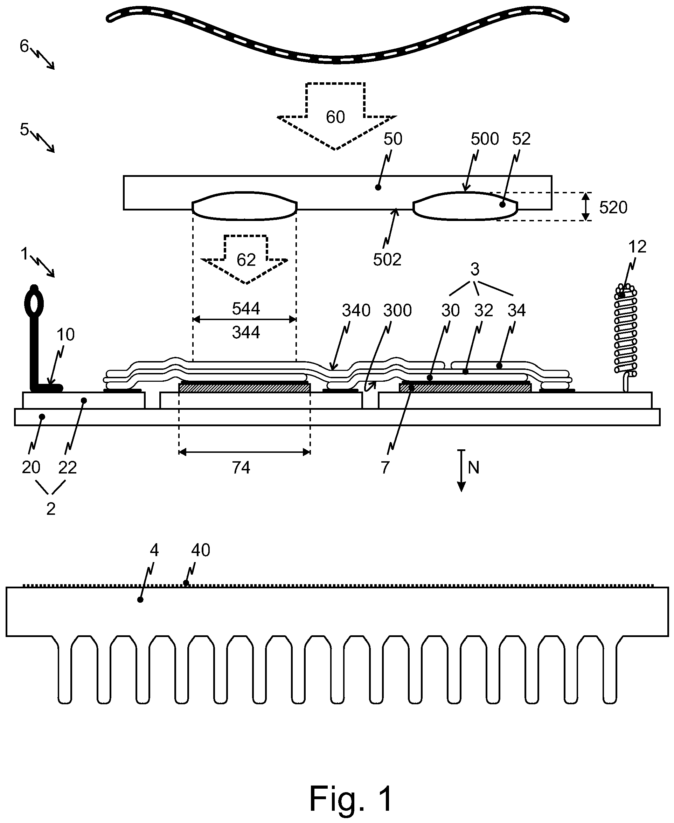

Figur 1 zeigt in schematischer Explosionsdarstellung eine Ausgestaltung einer leistungselektronischen Schalteinrichtung 1. Dargestellt ist ein grundsätzlich fachüblich ausgebildetes Substrat 2 mit einem Isolierstoffkörper 20 und hierauf angeordneten jeweils elektrisch voneinander isolierten Leiterbahnen 22, die unterschiedliche Potentiale, insbesondere Lastpotentiale, aber auch Hilfs-, insbesondere Schalt- und Messpotentiale, der Schalteinrichtung aufweisen. Konkret dargestellt sind hier drei Leiterbahnen 22 mit Lastpotentialen wie sie für eine Halbbrückentopologie typisch sind.

Auf zwei Leiterbahnen 22 ist jeweils ein Leistungshalbleiterbauelement 7 angeordnet, das fachüblich als Einzelschalter, beispielhaft als MOS-FET, oder als IGBT mit antiparallel geschalteter Leistungsdiode, die hier dargestellt ist, ausgebildet ist.

Die internen Verbindungen der Schalteinrichtung 1 sind ausgebildet mittels einer Verbindungseinrichtung 3 aus einem Folienverbund, der alternierend elektrisch leitende Folien 30, 34 und elektrisch isolierende Folien 32 aufweist. Hier weist der Folienverbund genau zwei leitende und eine dazwischen angeordnete isolierende Folie auf. Die dem Substrat 2 zugewandte Oberfläche dieses Folienverbunds 3 bildet hierbei dessen erste Hauptfläche 300 aus, während die gegenüberliegende dessen zweite Hauptfläche 340 ausbildet. Insbesondere die leitenden Folien 30, 34 der Verbindungseinrichtung 3 sind in sich strukturiert und bilden somit voneinander elektrisch isolierte Leiterbahnabschnitte aus. Diese Leiterbahnabschnitte verbinden insbesondere das jeweilige Leistungshalbleiterbauelement 7, genauer dessen Kontaktflächen auf der dem Substrat 2 abgewandten Seite, mit Leiterbahnen 22 des Substrats. In dieser Ausgestaltung sind die Leiterbahnabschnitte mit den Kontaktflächen des Substrats mittels einer Drucksinterverbindung stoffschlüssig verbunden.

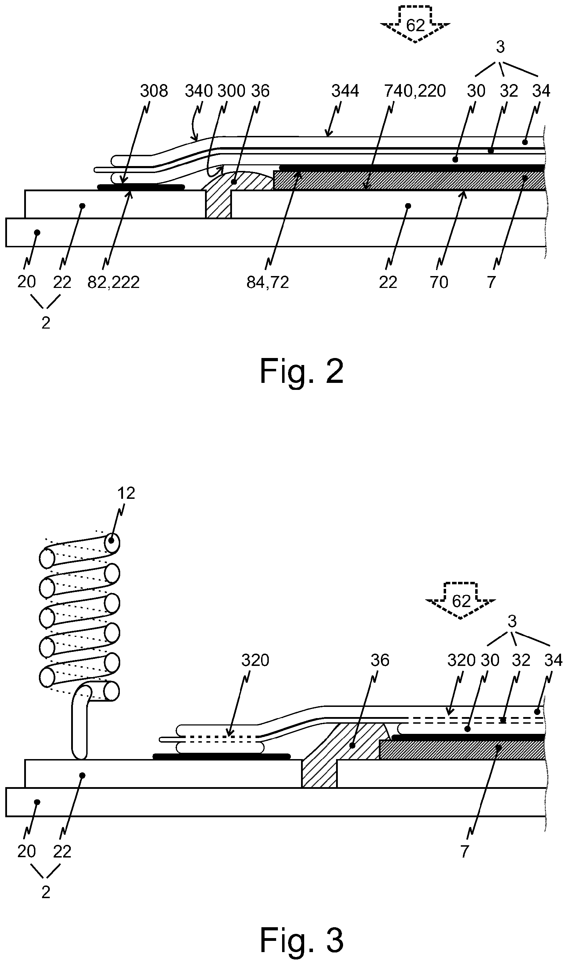

Ebenso sind hier die Leistungshalbleiterbauelemente 7, genauer deren Kontaktflächen der zweiten Hauptfläche (72, vgl. Figur 2), mittels einer Drucksinterverbindung (84, vgl. Figur 2) stoffschlüssig mit der Verbindungseinrichtung 3 verbunden.

Zur externen elektrischen Anbindung weist die leistungselektronische Schalteinrichtung 1 Last- und Hilfsanschlusselemente auf, wobei hier nur die Lastanschlusselemente dargestellt sind. Diese Lastanschlusselemente sind rein beispielhaft als Metallformkörper 10 ausgebildet, die mit einem Kontaktfuß mit einer Leiterbahn 22 des Substrats 2 stoffschlüssig, vorteilhafterweise ebenfalls mittels einer Drucksinterverbindung, verbunden sind. Ebenso fachüblich können diese Lastanschlusselemente als Kontaktfeder 12 ausgebildet sein. Grundsätzlich können auch Teile der Verbindungseinrichtung 3 selbst als Last- oder Hilfsanschlusselemente ausgebildet sein. Die nicht dargestellten Hilfsanschlusselemente, wie Gate- oder Sensoranschlüsse, sind vorzugsweise ebenfalls fachüblich ausgebildet.

Die fachübliche Druckeinrichtung 5 weist eine erste 502 dem Substrat 2 zugewandte und eine zweite dem Substrat 2 abgewandte Hauptfläche auf und ist hier der Übersicht halber beabstandet von der Verbindungseinrichtung 3 dargestellt. Die Druckeinrichtung 5 besteht aus einem Druckkörper 50 und einer Mehrzahl, dargestellt sind zwei, von Druckelementen 52. Der Druckkörper 50 ist besonders starr ausgebildet, um auf ihn eingeleiteten Druck homogen auf die Druckelemente 52 weitergeben zu können. Die Druckelementen 52 sind in Ausnehmung 500 des Druckkörpers 50, die als Vertiefung ausgehend von einer ersten Hauptfläche 502 ausgebildet sind, angeordnet. Sie füllen diese Ausnehmungen 500 vollständig aus stehen aus ihnen an der erster Hauptfläche 502 in Richtung auf das Substrat 2 hervor. Hierzu und vor dem Hintergrund der thermischen Belastungen beim Betrieb der Schalteinrichtung besteht der Druckkörper 50 aus einem hochtemperaturbeständigen thermoplastischen Kunststoff, insbesondere aus Polyphenylensulfid. Die Druckelemente 52 müssen im Betrieb und hierbei insbesondere bei unterschiedlichen Temperarturen, einen im Wesentlichen konstanten Druck ausüben können. Hierzu bestehen die Druckelemente 52 aus einem Elastomer, bevorzugt aus einem Silikonelastomer, besonders bevorzugt aus sog. vernetztem Flüssig-Silikon (LSR - Liquid Silicone Rubber). Das Verhältnis aus lateraler Ausdehnung 544 zu vertikaler Ausdehnung 520 des Druckkörpers 52 weist hier ein Verhältnis von 4 zu 1 auf.

Die Anordnung weist weiterhin einen Kühlkörper 4 auf, dessen Oberfläche mit einer wärmeleitenden Schicht 40 bedeckt ist auf der die leistungselektronische Schalteinrichtung 1, genauer deren Substrat 2, angeordnet ist. Die wärmeleitende Schicht 40 kann aufgrund der Ausgestaltung der Anordnung eine sehr geringe Dicke aufweisen, die hier zwischen 5µm und 10µm beträgt. Grundsätzlich könnte auf die wärmeleitende Schicht vollständig verzichtet werden. Dies ist abhängig von der Oberflächenbeschaffenheit, insbesondere der Rauigkeit des Kühlkörpers 4.

Alternativ kann die Isolationslage 20 des Substrats 2 als eine elektrisch isolierende Folie ausgebildet sein, die unmittelbar auf den Kühlkörper 4 laminiert ist. Auch in diesem Fall können die Leiterbahnen 22 als flächige Leitungselemente aus Kupfer ausgebildet sein. Vorteilhafterweise weist diese dann eine Dicke von 0,5mm bis 1,0mm auf.

Die Anordnung weist weiterhin eine Druckeinleiteinrichtung 6 auf, die oberhalb der Verbindungseinrichtung 3 angeordnet ist. Mittels dieser Druckeinleiteinrichtung 6, die sich, nicht dargestellt, gegen den Kühlkörper abstützt, wird Druck 60 auf den Druckkörper 50 eingeleitet. Dieser Druck 60 wird jeweils als Teildruck 62 mittels der Druckelemente 52 unmittelbar auf einen ersten Abschnitt 344 der zweiten Hauptfläche 340 des Folienverbunds 3 übertragen. Dieser erste Abschnitt 344 drückt nun mittelbar, unter Ausbildung der kraftschlüssigen Verbindung eine Kontaktfläche (740, vgl. Figur 2) der ersten Hauptfläche (70, vgl. Figur 2) des Leistungshalbleiterbauelements 7 auf eine zugeordnete Kontaktfläche (220, vgl. Figur 2) der zugeordneten Leiterbahn 22 des Substrats 2.

Der eingeleitete Druck 60 drückt weiterhin das gesamte Substrat 2 auf den Kühlkörper 4. Die beiden Druckkontakte, der elektrische leitende zwischen dem Substrat 2 und dem Leistungshalbleiterbauelement 7, wie auch zwischen dem Substrat 2 und dem Kühlkörper 4 erfolgt jeweils in Normalenrichtung N des

Leistungshalbleiterbauelements 7. Somit wird einerseits eine hoch effiziente, mit äußerst geringem Übergangswiderstand behaftetet, kraftschlüssige und elektrisch leitende Verbindung zwischen dem Substrat 2 und dem Leistungshalbleiterbauelement 7 ausgebildet. Andererseits wird gleichzeitig eine ebenso effiziente, thermisch leitende Verbindung zwischen dem Substrat 2 und dem Kühlkörper 4 ausgebildet, die genau an derjenigen Stelle mit der höchsten Wärmeentwicklung, also dem Leistungshalbleiterbauelement 7, ihre wirksamste Wärmeübertragung ausbildet.

Figur 2 zeigt eine Schnittansicht einer ersten Ausgestaltung einer, leistungselektronischen Schalteinrichtung 1, wie sie im Grunde bereits in Figur 1 dargestellt ist.

Dargestellt ist hier das Substrat 2, mit einer Isolierlage 20 und zwei Leiterbahnen 22. Auf der rechten Leiterbahn ist ein Leistungshalbleiterbauelement 7, ausgebildet als eine Leistungsdiode, angeordnet und elektrisch leitend mittels einer kraftschlüssigen Verbindung, hier einer Drucksinterverbindung 84, mit der ersten Hauptfläche der Verbindungseinrichtung 3 verbunden.

Das Leistungshalbleiterbauelement 7, genauer seine dem Substrat 2 abgewandte Kontaktfläche der zweiten Hauptfläche 72 ist mittels der Verbindungseinrichtung 3 mit der linken Leiterbahn 22 elektrisch leitend verbunden. Hierzu weist die Verbindungseinrichtung 3 eine erste elektrisch leitende Folie 30 auf, wobei deren Kontaktfläche mit der korrespondierenden Kontaktfläche des Leistungshalbleiterbauelements 7 mittels einer stoffschlüssigen Drucksinterverbindung 84, oder einer sonstigen fachüblichen stoffschlüssigen Verbindung, ausgebildet ist.

Die Verbindungseinrichtung 3 weist weiterhin eine elektrisch isolierende 32 und eine weitere elektrisch leitende Folie 34 auf, die zusammenwirkend die weitere schaltungsgereichte interne Verbindung der leistungselektronischen Schalteinrichtung 1 ausbilden.

Das Leistungshalbleiterbauelement 7, genauer dessen Kontaktfläche 740 der ersten Hauptfläche 70 ist mit der zugeordneten Leiterbahn 22, genauer deren Kontaktfläche 220, mittels einer kraftschlüssigen Verbindung elektrisch leitend verbunden. Die Ausbildung dieser stoffschlüssigen Verbindung erfolgt indem ein Teildruck 62, vgl. Figur 1, unmittelbar auf einen ersten Abschnitt 344 der zweiten Hauptfläche 340 der Verbindungseinrichtung, hier des Folienverbunds 3, eingeleitet wird. Dieser Druck wird über das Leistungshalbleiterbauelement 7 auf dessen Kontaktstelle 740 zur Kontaktstelle 220 der zugeordneten Leiterbahn 22 übertragen, wobei sich zwischen diesen Kontaktstellen die kraftschlüssige, elektrisch leitende Verbindung ausbildet. Die jeweiligen Kontaktstellen 220, 740 dieser kraftschlüssigen Verbindung sind hier in bevorzugter Weise mit einer Goldoberfläche, insbesondere einer wenige Mikrometer dünnen Goldschicht, versehen, da diese beste Kontakteigenschaften und Übergangswiderstände aufweisen. Zudem weisen die jeweiligen Kontaktstellen 220, 740 der kraftschlüssigen Verbindung eine Rautiefe (Rz) von weniger als 5µm, insbesondere von weniger als 2µm, und einen Mittenrauwert (Ra) von weniger als 1µm, insbesondere von weniger als 0,5µm, jeweils bestimmt gemäß EN ISO 4287, auf.

Das Leistungshalbleiterbauelement 7 ist elektrisch leitend mit der linken Leiterbahn 22 verbunden. Hierzu reicht die erste Metallfolie 30 des Folienverbunds 3 von der Kontaktstelle mit dem Leistungshalbleiterbauelement 7 bis zu einer Kontaktstelle 222 der linken Leiterbahn 22. Die dortige stoffschlüssige Verbindung der Kontaktstelle 308 der Verbindungseinrichtung 3 mit der Kontaktstelle 222 der Leiterbahn 22 des Substrats 2 ist mittels einer Drucksinterverbindung 82, oder einer sonstigen fachüblichen Verbindung, ausgebildet.

Zudem weist die leistungselektronische Schalteinrichtung 1 noch einen adhäsiven, hier gelartigen, Stoff 36 auf der zu dem Leistungshalbleiterbauelement 7 und zu einer zugeordneten Leiterbahn 22 zur haftenden Fixierung des
Leistungshalbleiterbauelements 7 auf dieser Leiterbahn 22 angeordnete ist. In dieser Ausgestaltung liegt dieser adhäsive Stoff 36 am Rand des
Leistungshalbleiterbauelements 7, wie auch auf dem Substrat an. Hierdurch entsteht eine haftende Verbindung zwischen dem Leistungshalbleiterbauelement 7 und dem Substrat, wie sie notwendig ist um insbesondere das erfindungsgemäße Verfahren ausführen zu können.

Figur 3 zeigt eine Schnittansicht einer zweiten Ausgestaltung einer leistungselektronischen Schalteinrichtung 1. Die elektrisch leitende Verbindung zwischen dem Leistungshalbleiterbauelement 7 und der Verbindungseinrichtung 3 ist hier wiederum mittels der oben beschriebenen stoffschlüssigen Verbindung ausgebildet. Die kraftschlüssige Verbindung des Leistungshalbleiterbauelements 7 mit der zugeordneten Leiterbahn 22 des Substrats ist ebenfalls wie oben beschrieben ausgebildet.

Im Unterschied zur ersten Ausgestaltung gemäß Figur 2 weist hier die Verbindungseinrichtung 3 in den Kontaktbereichen zum
Leistungshalbleiterbauelement 7 wie auch zur linken Leiterbahn 22 nur Abschnitte der ersten elektrisch leitenden Folie 30 auf, die nicht unmittelbar miteinander verbunden sind. Vielmehr sind in diesen Abschnitten Durchkontaktierungen 320 von der ersten 30 zur zweiten leitenden Folie 34 durch die isolierende Folie 32 hindurch angeordnet. Somit erfolgt die elektrische Verbindung zwischen der linken Leiterplatte 22 und dem Leistungshalbleiterbauelement 7 über die zweite elektrisch leitende Folie 34. Auf der linken Leiterbahn22 ist zudem ein Anschlusselement 12, hier exemplarisch als Federkontaktelement ausgebildet, dargestellt.

Der adhäsive, hier gelartige, Stoff 36 ist hier ebenfalls zu dem
Leistungshalbleiterbauelement 7 und zu einer zugeordneten Leiterbahn 22 zur haftenden Fixierung des Leistungshalbleiterbauelements 7 auf dieser Leiterbahn 22 angeordnet. Allerdings liegt dieser adhäsive Stoff 36 zusätzlich an der ersten Hauptfläche der Verbindungseinrichtung 3 an, wodurch auch diese haftend mit dem Substrat verbunden ist. Die Ausbildung der adhäsiven Verbindungen erfolgt hier auf grundsätzlich fachübliche Weise. Beispielhaft kann das Leistungshalbleiterbauelement mittels einer Halteeinrichtung temporär auf das Substrat gedrückt werden, anschließend der adhäsive Stoff 36 angeordnet werden und dann die Vernetzung dieses adhäsiven Stoffes eingeleitet werden, wodurch die haftende Verbindung entsteht. Sobald diese eine ausreichende Haftkraft erreicht hat, auch wenn die Vernetzung noch nicht vollständig erfolgt ist, kann die Halteeinrichtung wieder entfernt werden.

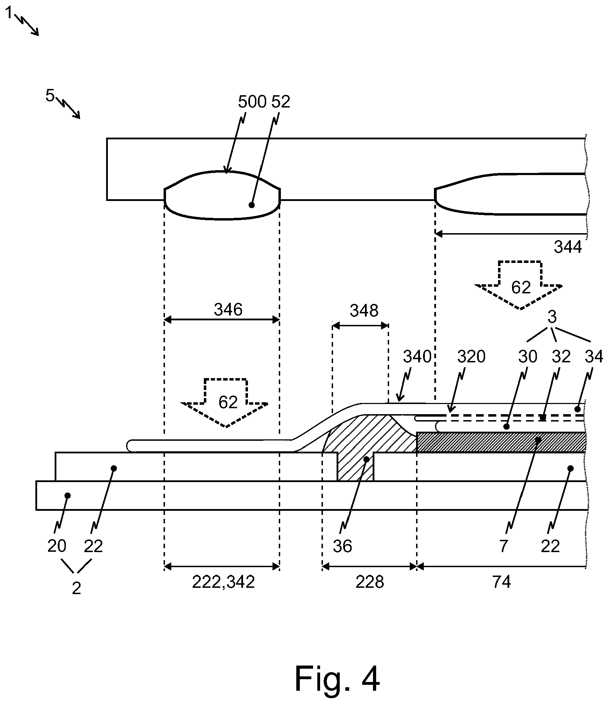

Figur 4 zeigt eine Schnittansicht einer dritten, gemäß dem erfindungsgemäßen Verfahren hergestellten, Ausgestaltung einer erfindungsgemäßen leistungselektronischen Schalteinrichtung 1. Das Substrat 2 mit dem Leistungshalbleiterbauelement 7 ist hier, wie bereits zu Figur 3 beschrieben, ausgebildet.

Auf dem Substrat 2 ist zwischen den beiden Leiterbahnen 22 und diese in Randbereichen überlappend, sowie an dem Leistungshalbleiterbauelement 7 anliegend, ein elektrisch isolierender adhäsiver Stoff 36, vorzugsweise ein Klebstoff auf Basis von Silikonkautschuk, angeordnet. Selbstverständlich kann der adhäsive Stoff auch als ein Polyimid oder ein Epoxidharz ausgebildet sein. Dieser adhäsive Stoff 36 sorgt ohne eine Druckbeaufschlagung mittels der Druckeinrichtung 5 für eine adhäsive, also zumindest haftende Verbindung zwischen dem Substrat 2 in dessen Abschnitt 228 und der Verbindungseinrichtung 3 in deren Abschnitt 348. Wesentlich ist hier, dass diese adhäsive Verbindung nicht zur elektrischen Leitung beiträgt und somit auch nur in Abschnitten 228,348 angeordnet ist, bei denen kein elektrisch leitender Kontakt zwischen der Verbindungseinrichtung 3 und dem Substrat 2, genauer einer Leiterbahn 22 oder dem Leistungshalbleiterbauelement 7, ausgebildet ist.

Die elektrisch leitende Verbindung zwischen dem Leistungshalbleiterbauelement 7 und der linken Leiterbahn 22 mittels der Verbindungseinrichtung 3 ist hier nicht durch die erste sondern die zweite elektrisch leitende Folie 34 ausgebildet. Hierbei ist im Gegensatz zur Ausgestaltung gemäß Figur 3 im Bereich der linken Leiterbahn 22 kein Abschnitt der ersten leitenden Folie 30 und somit auch keine Durchkontaktierung notwendig. Im Bereich des Leistungshalbleiterbauelements 7 ist die Ausgestaltung der Verbindungseinrichtung 3 wie unter Figur 3 beschrieben.

Die elektrisch leitende Verbindung zwischen der Verbindungseinrichtung 3 und dem Leistungshalbleiterbauelement 7, zwischen dem Leistungshalbleiterbauelement 7 und dem Substrat, sowie zwischen der Verbindungseinrichtung 3 und der Leiterbahn 22 des Substrats 2 ist jeweils als kraftschlüssige Verbindung ausgebildet. Hierzu wird jeweils ein Teildruck 62 (vgl. auch Figur 1) mittels jeweils einem zugeordneten Druckelement 52 der Druckeinrichtung 5 auf die jeweilige Verbindung eingeleitet. Hierbei wird also auf einen zweiten Abschnitt 346 der zweiten Hauptfläche 340 der Verbindungseinrichtung ein Teildruck 62 ausgeübt, wodurch eine Kontaktfläche 342 der zweiten elektrisch leitenden Folie 34 auf eine Kontaktfläche 222 der linken Leiterbahn 22 gedrückt und damit kraftschlüssig elektrisch leitend verbunden wird. Ebenso wird auf einen ersten Abschnitt 344 der zweiten Hauptfläche 340 der Verbindungseinrichtung ein Teildruck 62 ausgeübt, wodurch die Verbindungseinrichtung 3 auf das Leistungshalbleiterbauelement 7 und dieses auf das Substrat 2 gedrückt und damit jeweils kraftschlüssig elektrisch leitend verbunden wird.

Ein wesentlicher Vorteil dieser dritten Ausgestaltung der leistungselektronischen Schalteinrichtung 1 ist, dass hier keinerlei stoffschlüssige und elektrisch leitende Verbindung ausgebildet werden muss. Die Verbindungseinrichtung 3, das Leistungshalbleiterbauelement 7 und das Substrat 2 werden ausschließlich haftend mittels des adhäsiven Stoffs 36 miteinander verbunden. Erst im Betrieb der leistungselektronischen Schalteinrichtung 1 erfolgt die beschriebene Druckbeaufschlagung, die hier den kraftschlüssigen elektrisch leitenden Kontakt zwischen der Verbindungeinrichtung 3 und dem Leistungshalbleiterbauelement 7, zwischen dem Leistungshalbleiterbauelement 7 und dem Substrat 2, wie auch zwischen der Verbindungseinrichtung 3 und dem Substrat 2 ausbildet.

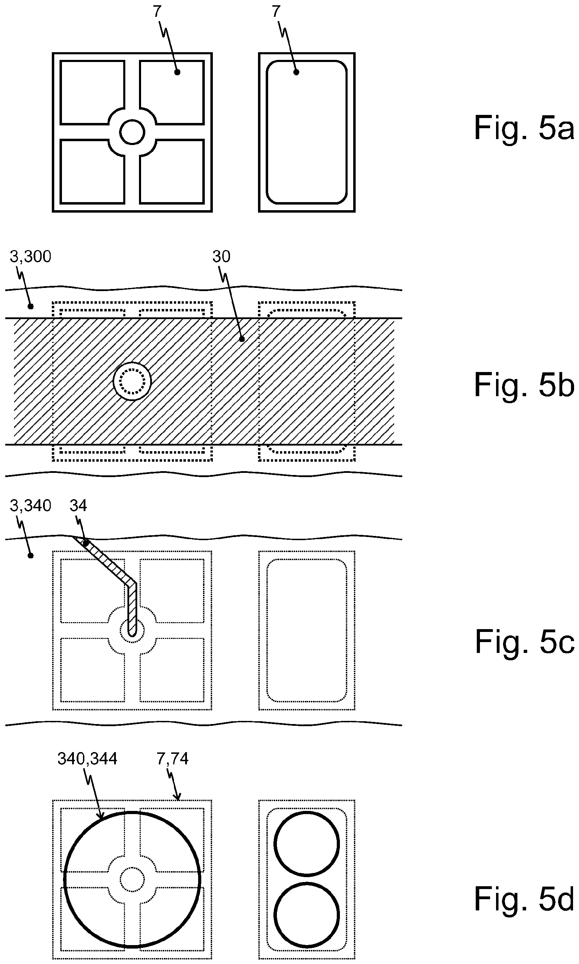

Figur 5 zeigt eine Draufsicht auf eine leistungselektronische Schalteinrichtung 1 in verschiedenen Schnittebenen. Die Schnittebene gemäß Fig. 5a zeigt zwei Leistungshalbleiterbauelemente 7, die typisch aber nicht dargestellt auf einer gemeinsamen Leiterbahn eines Substrats angeordnet sind. Es handelt sich hier ohne Beschränkung der Allgemeinheit um einen Transistor mit einer mittigen Gateanschlussfläche und diese umrahmende Emitteranschlussflächen und um eine Diode mit einer Kathodenanschlussfläche.

Fig. 5b zeigt die erste, in sich strukturierte, elektrisch leitende Folie 30 der Verbindungseinrichtung 3. Diese bildet eine elektrisch leitende Verbindung zwischen den Emitteranschlussflächen des Transistors und der Kathodenanschlussfläche der Diode aus. Hierbei wird die Gateanschlussfläche des Transistors ausgespart.

Fig. 5c zeigt die zweite in sich strukturierte elektrisch leitende Folie 34 der Verbindungseinrichtung 3. Diese bildet eine elektrisch leitende Verbindung zur Gateanschlussfläche des Transistors.

Fig. 5d zeigt quasi den Fußabdruck der den Leistungshalbleiterbauelementen 7 zugeordneten Kontaktelementen der Kontakteinrichtung, wobei dem Transistor aufgrund seiner quadratischen Grundform nur ein Kontaktelement und der Diode aufgrund ihrer rechteckigen Grundform zwei Kontaktelemente zugeordnet sind. Der jeweilige Fußabdruck entspricht denjenigen ersten Abschnitten 344 auf der zweiten Hauptfläche 340 der Verbindungseinrichtung 3, die in Normalenrichtung fluchtend zu den Leistungshalbleiterbauelementen angeordnet sind und hierbei auf das jeweilige Leistungshalbleiterbauelement projiziert sind. Hierbei wird ersichtlich, dass die Fläche des Fußabdrucks, also diejenige Fläche die zur Druckeinleitung bestimmt ist, einen möglichst großen Teil der Fläche des Leistungshalbleiterbauelements abdeckt, ohne über diese hinauszugehen.

## Patentansprüche

1. Leistungselektronische Schalteinrichtung (1) mit einem Substrat (2), einem hierauf angeordneten Leistungshalbleiterbauelement (7), mit einer Verbindungseinrichtung (3) und mit einer Druckeinrichtung (5),
wobei das Substrat (2) gegeneinander elektrisch isolierte Leiterbahnen (22) aufweist und auf einer der Leiterbahnen (22) ein Leistungshalbleiterbauelement (7) angeordnet ist, wobei ein adhäsiver Stoff (36) zu dem Leistungshalbleiterbauelement (7) und zu einer zugeordneten Leiterbahn (22) zur haftenden Fixierung des Leistungshalbleiterbauelements (7) auf dieser Leiterbahn (22) angeordnet ist,
wobei die Verbindungseinrichtung (3) als Folienverbund mit einer elektrisch leitenden (30, 34) und einer elektrisch isolierenden Folie (32) ausgebildet ist und somit eine erste und eine zweite Hauptfläche (300, 340) ausbildet, wobei die Schalteinrichtung mittels der Verbindungseinrichtung (3) intern schaltungsgerecht verbunden ist und wobei eine Kontaktfläche der ersten Hauptfläche (70) des Leistungshalbleiterbauelements (7) mit einer ersten Kontaktfläche (220) einer zugeordneten Leiterbahn (22) des Substrats (2) kraftschlüssig und elektrisch leitend verbunden ist, wobei
das Leistungshalbleiterbauelement (7) mit seiner zweiten Hauptfläche (72) mit einer zugeordneten Kontaktfläche der ersten Hauptfläche (300) der Verbindungseinrichtung (3) kraftschlüssig und elektrisch leitend verbunden ist, hierzu die Druckeinrichtung (5) einen Druckkörper (50) und ein hiervon in Richtung des Leistungshalbleiterbauelements (7) hervorstehendes Druckelement (52) aufweist, wobei das Druckelement (52) auf einen ersten Abschnitt (344) der zweiten Hauptfläche (340) des Folienverbunds (3) drückt und hierbei dieser erste Abschnitt in Projektion entlang der Normalenrichtung (N) des Leistungshalbleiterbauelements (7) innerhalb der Fläche (74) des Leistungshalbleiterbauelements (7) angeordnet ist.

2. Schalteinrichtung nach Anspruch 1, wobei
eine zweite Kontaktfläche (308) der Verbindungseinrichtung kraft- oder stoffschlüssig und elektrisch leitend mit einer Kontaktfläche (228) der zugeordneten Leiterbahnen (22) des Substrats (2) verbunden ist.

3. Schalteinrichtung nach einem der vorhergehenden Ansprüche, wobei der Druckkörper (50) eine erste Ausnehmung (500) aufweist, aus der das Druckelement (52) hervorsteht.

4. Schalteinrichtung nach Anspruch 4, wobei
die erste Ausnehmung (500) des Druckkörpers (50) als Vertiefung ausgehend von einer ersten Hauptfläche (502) ausgebildet ist, das Druckelement (52) die Ausnehmung (500) des Druckkörpers (50) vollständig oder annährend vollständig ausfüllt und das Druckelement (52) aus der Ausnehmung (500) des Druckkörpers an dessen erster Hauptfläche (502) hervorsteht.

5. Schalteinrichtung nach einem der vorhergehenden Ansprüche, wobei der Druckkörper (50) aus einem hochtemperaturbeständigen thermoplastischen Kunststoff, insbesondere aus Polyphenylensulfid, und das Druckelement (52) aus einem Elastomer, vorzugsweise einem Silikonelastomer, insbesondere aus einem vernetzten Flüssig-Silikon, besteht.

6. Schalteinrichtung nach einem der vorhergehenden Ansprüche, wobei das Verhältnis aus laterale Ausdehnung (544) zu vertikaler Ausdehnung (520) des Druckkörpers (52) ein Verhältnis von mehr als 2 zu 1, insbesondere von mehr als 4 zu 1 aufweist.

7. Schalteinrichtung nach einem der vorhergehenden Ansprüche, wobei der Flächeninhalt des ersten Abschnitts (344) mindestens 20%, insbesondere mindestens 50% der Fläche (74) des zugeordneten Leistungshalbleiterbauelements (7) aufweist.

8. Anordnung mit einer elektronischen Schalteinrichtung (1) nach einem der vorhergehenden Ansprüche, mit einer Kühleinrichtung (7) und mit einer Druckeinleiteinrichtung (6), wobei die Druckeinleiteinrichtung (6) sich mittelbar oder unmittelbar gegen die Kühleinrichtung (4) abstützt, vorzugsweise mittig auf die Druckeinrichtung (5) Druck einleitet und hierdurch die Schalteinrichtung (1) kraftschlüssig mit der Kühleinrichtung (7) verbunden ist.

9. Anordnung nach Anspruch 8, wobei
zwischen Substrat (2) und der Kühleinrichtung (4) eine wärmeleitende Schicht (40) mit einer Dicke von weniger als 20µm, insbesondere von weniger als 10µm, insbesondere von weniger als 5µm angeordnet ist.

10. Anordnung nach Anspruch 9, wobei
die Kühleinrichtung (7) eine vorzugsweise metallische Grundplatte eines Leistungshalbleitermoduls oder ein Kühlkörper ist.

11. Verfahren zur Herstellung einer leistungselektronischen Schalteinrichtung (1) nach einem der Ansprüche 1 bis 8 mit den Schritten:
a. Bereitstellen des Substrats (2) mit einer Isolationslage (20) und mit gegeneinander elektrisch isolierten Leiterbahnen (22);
b. Bereitstellen der Verbindungseinrichtung (3) ausgebildet als Folienstapel alternierend ausgebildet mit zwei elektrisch leitenden, in sich strukturierten Folien (30, 34) und einer elektrisch isolierenden Folie (32) zwischen den beiden leitenden Folien (30,34);
c. Anordnen des Leistungshalbleiterbauelements (7) auf einer zugeordneten Leiterbahn (22);
d. Anordnen des adhäsiven Stoffs (36) zu dem Leistungshalbleiterbauelement (7) und zu einer zugeordneten Leiterbahn (22) zur haftenden Fixierung des Leistungshalbleiterbauelements (7) auf dieser Leiterbahn (22);
e. Anordnen und haftendes Verbinden der Verbindungseinrichtung (3) mit dem Substrat (2) mittels des adhäsiven Stoffs (36);
f. Druckeinleitung mittels einer Druckeinrichtung (5) und einer Druckeinleiteinrichtung (6) auf die Verbindungseinrichtung (3) derart, dass zwischen dem Leistungshalbleiterbauelement (7) und der zugeordneten Leiterbahn (22) des Substrats (2) eine kraftschlüssige elektrisch leitende Verbindung ausgebildet wird, wobei sowohl zwischen der Verbindungseinrichtung (3) und dem Leistungshalbleiterbauelement (7), wie auch zwischen der Verbindungseinrichtung (3) und einer zugeordneten Leiterbahn (22) eine kraftschlüssige elektrisch leitende Verbindung ausgebildet wird.

## Claims

1. Power electronic switching device (1) comprising a substrate (2), a power semiconductor component (7) arranged thereon, comprising a connection device (3) and comprising a pressure device (5),
wherein the substrate (2) has conductor tracks (22) electrically insulated from one another, and a power semiconductor component (7) is arranged on one of the conductor tracks (22), wherein an adhesive substance (36) is arranged with respect to the power semiconductor component (7) and with respect to an assigned conductor track (22) for adhesively fixing the power semiconductor component (7) on said conductor track (22),
wherein the connection device (3) is embodied as a film composite comprising an electrically conductive film (30, 34) and an electrically insulating film (32) and thus forms a first and a second main surface (300, 340), wherein the switching device is connected in a circuit-conforming manner internally by means of the connection device (3), and wherein a contact area of the first main surface (70) of the power semiconductor component (7) is connected to a first contact area (220) of an assigned conductor track (22) of the substrate (2) in a force-locking and electrically conductive manner, wherein the power semiconductor component (7) is connected by its second main surface (72) to an assigned contact area of the first main surface (300) of the connection device (3) in a force-locking and electrically conductive manner, for this purpose the pressure device (5) has a pressure body (50) and a pressure element (52) projecting therefrom in the direction of the power semiconductor component (7), wherein the pressure element (52) presses onto a first section (344) of the second main surface (340) of the film composite (3) and in this case said first section is arranged within the area (74) of the power semiconductor component (7) in projection along the direction of the normal (N) to the power semiconductor component (7).

2. Switching device according to Claim 1, wherein
a second contact area (308) of the connection device is connected to a contact area (228) of the assigned conductor tracks (22) of the substrate (2) in a force-locking or materially-bonded and electrically conductive manner.

3. Switching device according to any of the preceding claims, wherein
the pressure body (50) has a first cutout (500), from which the pressure element (52) projects.

4. Switching device according to Claim 4, wherein
the first cutout (500) of the pressure body (50) is embodied as a depression proceeding from a first main surface (502), the pressure element (52) completely or approximately completely fills the cutout (500) of the pressure body (50), and the pressure element (52) projects from the cutout (500) of the pressure body at the first main surface (502) thereof.

5. Switching device according to any of the preceding claims, wherein
the pressure body (50) consists of a high-temperature-resistant thermoplastic, in particular of polyphenylene sulphide, and the pressure element (52) consists of an elastomer, preferably a silicone elastomer, in particular of a crosslinked liquid silicone.

6. Switching device according to any of the preceding claims, wherein
the ratio of lateral extent (544) to vertical extent (520) of the pressure body (52) has a ratio of more than 2 to 1, in particular of more than 4 to 1.

7. Switching device according to any of the preceding claims, wherein
the surface area of the first section (344) has at least 20%, in particular at least 50%, of the area (74) of the assigned power semiconductor component (7) .

8. Arrangement comprising an electronic switching device (1) according to any of the preceding claims, comprising a cooling device (7) and comprising a pressure introducing device (6), wherein the pressure introducing device (6) is supported indirectly or directly against the cooling device (4) and introduces pressure preferably centrally on the pressure device (5), and the switching device (1) is thereby connected to the cooling device (7) in a force-locking manner.

9. Arrangement according to Claim 8, wherein
a heat-conducting layer (40) having a thickness of less than 20 µm, in particular of less than 10 µm, in particular of less than 5 µm, is arranged between the substrate (2) and the cooling device (4).

10. Arrangement according to Claim 9, wherein
the cooling device (7) is a preferably metallic baseplate of a power semiconductor module or a heat sink.

11. Method for producing a power electronic switching device (1) according to any of Claims 1 to 8, comprising the following steps:
a. providing the substrate (2) comprising an insulation layer (20) and comprising conductor tracks (22) electrically insulated from one another;
b. providing the connection device (3) embodied as a film stack embodied alternately with two electrically conductive, inherently structured films (30, 34) and an electrically insulating film (32) between the two conductive films (30, 34);
c. arranging the power semiconductor component (7) on an assigned conductor track (22);
d. arranging the adhesive substance (36) with respect to the power semiconductor component (7) and with respect to an assigned conductor track (22) for adhesively fixing the power semiconductor component (7) on said conductor track (22);
e. arranging and adhesively connecting the connection device (3) to the substrate (2) by means of the adhesive substance (36);
f. introducing pressure on the connection device (3) by means of a pressure device (5) and a pressure introducing device (6) in such a way that a force-locking electrically conductive connection is formed between the power semiconductor component (7) and the assigned conductor track (22) of the substrate (2),
wherein
a force-locking electrically conductive connection is formed both between the connection device (3) and the power semiconductor component (7), and between the connection device (3) and an assigned conductor track (22).

## Revendications

1. Dispositif de commutation électronique de puissance (1) comprenant un substrat (2), un composant à semi-conducteur de puissance (7) disposé sur ledit substrat, un dispositif de connexion (3) et un dispositif de pression (5), le substrat (2) comportant des pistes conductrices (22) qui sont électriquement isolées les unes des autres et un composant à semi-conducteur de puissance (7) étant disposé sur l'une des pistes conductrices (22), une substance adhésive (36) étant ajoutée au composant à semi-conducteur de puissance (7) et à une piste conductrice associée (22) afin de fixer de manière adhésive le composant à semi-conducteur de puissance (7) sur cette piste conductrice (22),
le dispositif de connexion (3) étant conçu comme un film composite comprenant un film électriquement conducteur (30, 34) et un film électriquement isolant (32) et formant ainsi des première et deuxième surfaces principales (300, 340), le dispositif de commutation étant connecté en interne au moyen du dispositif de connexion (3) conformément au montage et une surface de contact de la première surface principale (70) du composant à semi-conducteur de puissance (7) étant connectée en force et de manière électriquement conductrice à une première surface de contact (220) d'une piste conductrice associée (22) du substrat (2),
le composant à semi-conducteur de puissance (7) étant connecté en force et de manière électriquement conductrice par sa deuxième surface principale (72) à une surface de contact associée de la première surface principale (300) du dispositif de connexion (3), le dispositif de pression (5) comportant pour cela un corps de pression (50) et un élément de pression (52) saillant dudit corps de pression en direction du composant à semi-conducteur de puissance (7), l'élément de pression (52) exerçant une pression sur une première portion (344) de la deuxième surface principale (340) du film composite (3) et cette première portion étant alors disposée en projection le long de la direction normale (N) du composant à semi-conducteur de puissance (7) à l'intérieur de la surface (74) du composant à semi-conducteur de puissance (7).

2. Dispositif de commutation selon la revendication 1, une deuxième surface de contact (308) du dispositif de connexion étant connectée en force ou par liaison de matière et de manière électriquement conductrice à une surface de contact (228) des pistes conductrices associées (22) du substrat (2).

3. Dispositif de commutation selon l'une des revendications précédentes, le corps de pression (50) comportant un premier évidement (500) duquel l'élément de pression (52) fait saillie.

4. Dispositif de commutation selon la revendication 4, le premier évidement (500) de l'élément de pression (50) étant conçu comme un évidement partant d'une première surface principale (502), l'élément de pression (52) remplissant complètement ou presque complètement l'évidement (500) du corps de pression (50) et l'élément de pression (52) saillant de l'évidement (500) du corps de pression au niveau de sa première surface principale (502) .

5. Dispositif de commutation selon l'une des revendications précédentes, le corps de pression (50) comprenant une matière thermoplastique résistant aux hautes températures, en particulier du sulfure de polyphénylène, et l'élément de pression (52) comprenant un élastomère, de préférence un élastomère de silicone, en particulier une silicone liquide réticulée.

6. Dispositif de commutation selon l'une des revendications précédentes, le rapport de l'étendue latérale (544) à l'étendue verticale (520) du corps de pression (52) étant un rapport de plus de 2 à 1, en particulier de plus de 4 à 1.

7. Dispositif de commutation selon l'une des revendications précédentes, la superficie de la première portion (344) comportant au moins 20 %, en particulier au moins 50 %, de la surface (74) du composant à semi-conducteur de puissance associé (7).

8. Ensemble comprenant un dispositif de commutation électronique (1) selon l'une des revendications précédentes, un dispositif de refroidissement (7) et un dispositif d'injection de pression (6), le dispositif d'injection de pression (6) venant en appui direct ou indirect contre le dispositif de refroidissement (4), injectant de préférence une pression au centre du dispositif de pression (5) et reliant ainsi le dispositif de commutation (1) en force au dispositif de refroidissement (7).

9. Ensemble selon la revendication 8, une couche conductrice de chaleur (40) d'une épaisseur inférieure à 20 µm, notamment inférieure à 10 µm, notamment inférieure à 5 µm, étant disposée entre le substrat (2) et le dispositif de refroidissement (4).

10. Ensemble selon la revendication 9, le dispositif de refroidissement (7) étant une plaque de base de préférence métallique d'un module à semi-conducteur de puissance ou d'un dissipateur thermique.

11. Procédé de fabrication d'un dispositif de commutation électronique de puissance (1) selon l'une des revendications 1 à 8, le procédé comprenant les étapes suivante :
a. pourvoir le substrat (2) d'une couche isolante (20) et de pistes conductrices (22) isolées électriquement les unes des autres ;
b. fournir le dispositif de connexion (3) sous la forme d'un empilement de films formé alternativement de deux films en soi structurés électriquement conducteurs (30, 34) et d'un film électriquement isolant (32) entre les deux films conducteurs (30, 34) ;
c. disposer le composant à semi-conducteur de puissance (7) sur une piste conductrice associée (22) ;
d. disposer la substance adhésive (36) sur le composant à semi-conducteur de puissance (7) et sur une piste conductrice associée (22) de façon à fixer de manière adhésive le composant à semi-conducteur de puissance (7) sur cette piste conductrice (22) ;
e. disposer et relier de manière adhésive le dispositif de connexion (3) sur le substrat (2) au moyen de la substance adhésive (36) ;
f. injecter de la pression au moyen d'un dispositif de pression (5) et d'un dispositif d'injection de pression (6) sur le dispositif de connexion (3) de façon à former une connexion en force électriquement conductrice entre le composant à semi-conducteur de puissance (7) et la piste conductrice associée (22) du substrat (2),
une connexion en force électriquement conductrice étant formée à la fois entre le dispositif de connexion (3) et le composant à semi-conducteur de puissance (7) et entre le dispositif de connexion (3) et une piste conductrice associée (22).
